# EUROPÄISCHE PATENTSCHRIFT

(11) **EP 0 984 876 B1**
(45) Veröffentlichungstag und Bekanntmachung des Hinweises auf die Patenterteilung: **11.01.2006**
(21) Anmeldenummer: 99910102.5
(22) Anmeldetag: 05.02.1999
(51) Int. Cl.: B60S 1/38, C23C 16/02, C23C 16/50, C23C 14/02, C23C 14/34, C23C 14/22

(54) **BESCHICHTUNGSVERFAHREN EINES WISCHERGUMMIS**
METHOD FOR COATING A RUBBER WIPER BLADE
PROCEDE D'ENDUCTION POUR UNE RACLETTE D'ESSUIE-GLACE

(30) Priorität: 02.04.1998 DE 19814805
(43) Veröffentlichungstag der Anmeldung: 15.03.2000
(73) Patentinhaber: ROBERT BOSCH GMBH, 70442 Stuttgart (DE)
(72) Erfinder: LEUTSCH, Wolfgang, D-77830 Bühlertal (DE); RAUSCHNABEL, Johannes, D-70197 Stuttgart (DE); FORGET, Jeanne, D-70195 Stuttgart (DE); VOIGT, Johannes, D-71229 Leonberg (DE)
(86) Internationale Anmeldenummer: PCT/DE1999/000301
(87) Internationale Veröffentlichungsnummer: WO 1999/051471

(56) Entgegenhaltungen:
- EP-A- 0 260 516
- EP-A- 0 330 524
- EP-A- 0 691 419
- DE-A- 19 731 181
- GB-A- 2 202 237
- US-A- 3 669 719
- US-A- 5 527 629
- US-A- 5 635 087
- PATENT ABSTRACTS OF JAPAN vol. 097, no. 009, 30. September 1997 & JP 09 125253 A (NISSIN ELECTRIC CO LTD), 13. Mai 1997
- PATENT ABSTRACTS OF JAPAN vol. 009, no. 200 (C-298), 16. August 1985 & JP 60 067655 A (NIPPON OIL SEAL KOGYO KK), 18. April 1985
- PATENT ABSTRACTS OF JAPAN vol. 098, no. 006, 30. April 1998 & JP 10 035418 A (FUKOKU CO LTD), 10. Februar 1998
- PATENT ABSTRACTS OF JAPAN vol. 016, no. 351 (C-0968), 29. Juli 1992 & JP 04 107254 A (OHBAYASHI CORP), 8. April 1992

## Beschreibung

### Stand der Technik

Die Erfindung geht aus von einem Verfahren zum Beschichten eines Wischergummis nach dem Oberbegriff des Anspruchs 1.

Bekannte Scheibenwischer besitzen einen Wischarm, der aus einem auf einer Antriebsachse befestigten Befestigungsteil, einem mit diesem über ein Kniegelenk verbundenen Gelenkteil und aus einer sich an das Gelenkteil starr anschließenden Wischstange aufgebaut ist. Ferner besitzt der Scheibenwischer ein Wischblatt, das ein Tragbügelsystem und einen von diesem gehaltenen Wischergummi aufweist. Das Wischblatt ist am Wischarm angelenkt, indem ein hakenförmiges Ende der Wischstange zwischen zwei Seitenwangen des Tragbügelsystems greift und einen Gelenkbolzen umfasst. Das so gebildete Gelenk führt das Wischblatt mit dem Wischergummi über eine Kraftfahrzeugscheibe, wobei das Gelenkteil und das Tragbügelsystem es ermöglichen, dass sich der Wischergummi einer Wölbung der Kraftfahrzeugscheibe anpasst. Ein erforderlicher Anpressdruck des Wischergummis auf der Kraftfahrzeugscheibe wird mit mindestens einer Zugfeder erreicht, die das Befestigungsteil und das Gelenkteil gemeinsam mit der Wischstange über das Kniegelenk verspannt.

Der Wischergummi besteht aus einem Elastomer, z.B. einem Natur- oder Synthesekautschuk. Er hat eine Kopfleiste, die über einen Kippsteg mit einer auf der zu wischenden Scheibe aufliegenden Wischlippe verbunden ist. Durch den Kippsteg kann die Wischlippe im Umkehrpunkt der Wischbewegung in die entgegengesetzte Richtung umklappen, sodass sie stets einen günstigen Winkel zur Windschutzscheibe einnimmt. Wird der Scheibenwischer betätigt, gleitet der Wischergummi mit der Wischlippe über die Kraftfahrzeugscheibe, wobei er sich durch Reibung zwischen der Wischlippe und der Windschutzscheibe abnutzt. Ferner wirken Umwelteinflüsse auf den Wischergummi, wie beispielsweise Temperaturschwankungen, UV-Strahlung, Salzwasser, Abgase usw., die zu einer frühzeitigen Werkstoffalterung und einem verstärkten Verschleiß führen können.

Grundsätzlich kann der Verschleiß durch eine bessere Gleiteigenschaft und damit geringere Reibung und/oder durch einen härteren Wischergummi reduziert werden. Ein nasschemisches Härteverfahren ist beispielsweise aus der DE 26 23 216 bekannt, bei dem der Wischergummi zunächst mit Chlor oder Brom halogenisiert und anschließend mit einer stark oder mäßig alkalischen Lösung bei Temperaturen bis zu 100° C behandelt wird.

Nachdem der Wischergummi beispielsweise durch Extrusion hergestellt ist, besitzt dieser eine glatte günstige Oberfläche. Von dem nasschemischen Härtevorgang wird der Wischergummi insgesamt erfasst, sodass sich seine Werkstoffeigenschaften auch dort verändern, wo es nicht erforderlich oder gar unerwünscht ist. Ferner werden die Mikrostruktur und Makrostruktur des Wischergummis verändert, beispielsweise durch Chlor und Wärme. Der Wischergummi wird in der Regel rauer und spröder, wodurch er schlechter auf der Windschutzscheibe anliegt und schlechtere Wischeigenschaften erhält. Ferner besteht die Gefahr, dass kleinere und größere Bestandteile beim Wischen über die Windschutzscheibe aus dem Wischergummi herausbrechen. Für eine gute Reinigungsqualität sollte ferner die Wischlippe des Wischergummis beim Richtungswechsel schnell und leicht ohne großen Widerstand umklappen. Durch einen härteren und spröderen Werkstoff wird der Widerstand im Werkstoff jedoch erhöht, der Umklappvorgang verhindert oder zumindest verzögert und das Wischblatt neigt zum Rattern.

Aus der BE 84 8 964 A ist ein Beschichtungsverfahren bekannt, das nach einem Härteverfahren die Gleiteigenschaften verbessert. Der Wischergummi wird danach in einem nasschemischen Verfahren zumindest im Bereich der Lippe mit einer Schicht überzogen, die weicher ist als das Grundmaterial und daher nicht sehr verschleißfest ist.

Beschichtungsverfahren, bei denen Beschichtungsmaterialien in einen dampfförmigen Zustand versetzt oder in einem dampfförmigen Zustand verwendet, zur Oberfläche des zu beschichtenden Gegenstands befördert und auf diesem abgelagert werden, können grundsätzlich in PVD-Verfahren (Physical Vapour Deposition, Physikalisches Dampfablagerungs-Verfahren) und CVD-Verfahren (Chemical Vapour Deposition, Chemisches Dampfablagerungs-Verfahren) unterteilt werden. Derartige Beschichtungsverfahren sind insbesondere bekannt, Siliziumscheiben für integrierte Halbleiterschaltungen zu beschichten (vgl.: Widmann, Dietrich: Technologie hochintegrierter Schaltungen, D. Widmann; H. Mader; H. Friedrich. - 2 Aufl. Springer, 1996, S. 13-34). Die CVD-Verfahren, auch als Gasphasenabscheidungs-Verfahren bezeichnet, sind durch chemische Reaktionen geprägt, d.h. die verwendeten Beschichtungsmaterialien reagieren auf der zu beschichtenden Oberfläche in einer chemischen Reaktion zu einer Schicht. Die PVD-Verfahren sind dagegen in erster Linie durch physikalische Abläufe geprägt, wie beispielsweise zerstäuben einer Kathode, wobei jedoch keine klare Grenze zwischen den Verfahren gezogen werden kann.

Aus den Patent Abstracts of Japan Bd. 097, Nr. 009, 30. September 1997 (1997-09-30) und JP 09 125253 A (Nissin Electric CO LTD, 13. Mai 1997 (1997-05-13) ist ein Verfahren zum Beschichten eines Wischergummis gemäß dem Oberbegriff des Anspruchs 1 bekannt. Die Beschichtung erfolgt durch ein PVD-Verfahren, bei dem die Generierung und Aktivierung des dampfförmigen Beschichtungsmaterials thermisch und plasmagestützt erfolgt und einen Kohlenstofffilm mit einer vorzüglichen Gleiteigenschaft auf der Wischergummioberfläche bildet.

Ferner ist aus der JP 60 067655 A und den entsprechenden Patent Abstracts of Japan, Bd. 009, Nr. 200 (C-298), 16. August 1985 (1985-08-16) und der Database WPI Section CH, Week 8522 Derwent Publications Ltd, London, GB; Class A14, AN 85-131087 XP002112335 ein Verfahren zum Beschichten eines Wischergummis bekannt, bei dem im ersten Schritt auf dem Grundmaterial teilweise oder ganz eine untere Schicht durch ein Hochfrequenzsputterverfahren gebildet wird, die Fluor enthält, und in einem zweiten Schritt ein weiterer Film auf die untere Lage gebildet wird aus einem Kunststoffgemisch, das ein oder mehrere der Komponenten Kupfer, Zink, Kohlenstoff, Glas, Molybdändisulfid oder Boronnitrid und Fluor enthält. Dadurch wird der Reibwiderstand stark reduziert.

Schließlich ist aus den Patent Abstracts of Japan, Bd. 089, Nr. 006, 30. April 1998 (1998-04-30) und JP 10 035418 A ein Verfahren zum Beschichten eines Wischergummis bekannt, bei dem auf dem Wischergummi mittels eines Plasma-CVD-Verfahrens eine Kohlenstoffschicht erzeugt wird, die niedrigere Reibeigenschaften und einen guten Verschleißwiderstand aufweist.

### Vorteile der Erfindung

Nach der Erfindung weist das Verfahren die Merkmale des Anspruchs 1 auf.

Der vorteil des erfindungsgemäßen Verfahrens besteht darin, dass viele verschiedene, besonders dünne, geschlossene und hochvernetzte Schichten geschaffen werden. Dünne Schichten können hart und trotzdem flexibel ausgeführt werden. Sie platzen bei Verformungen des Wischergummis nicht auf. Die geschlossene Oberfläche bleibt erhalten und führt zu einer hohen chemischen Resistenz, indem keine aggressiven Medien, wie Salzwasser, Abgase usw., zwischen die Schicht und den Wischergummi gelangen, den Wischergummi angreifen und die Schicht ablösen.

Ferner wird für dünne Schichten wenig Beschichtungsmaterial benötigt. Es fällt wenig Abfallmaterial an und es müssen geringe Mengen an Beschichtungsmaterial vorgehalten werden. Durch die geringen Mengen an Beschichtungsmaterial können die Beschichtungsanlagen leicht nach außen dicht verschlossen werden. Chemisch aggressive Lösungsmittel sind nicht erforderlich. Die aufgebrachten Schichten benötigen keine zeitraubenden Trocknungs- bzw. Aushärtungszyklen. Die Verfahren sind umweltfreundlich, wirtschaftlich und eignen sich gut für eine Großserienproduktion.

Ferner besteht der besondere Vorteil darin, dass während der Wischergummi beschichtet wird, die Prozessparameter einfach variiert, die Schichteigenschaften innerhalb einer dünnen Schicht verändert und damit entsprechenden Anforderungen angepasst werden können. Im inneren Bereich am Wischergummi kann ein elastisch weiches, den Eigenschaften des Wischergummis angepasstes und ein nach außen hartes, verschleißfestes Schichtsystem in einem Prozess erreicht werden.

Durch den Übergang von einer weichen zu einer dünnen, harten Schicht in einem insgesamt dünnen Schichtsystem, ist dieses in sich elastisch, beeinflusst nur geringfügig die Elastizität des Wischergummis und ist mit diesem fest und sicher verbunden. Das Schichtsystem platzt nicht ab, wenn der Wischergummi verformt wird, und ist chemisch resistent.

Besonders vorteilhaft ist ein gleichmäßiger Übergang von dem elastisch weichen zu dem verschleißfesten harten Bereich. In einer Ausgestaltung der Erfindung wird vorgeschlagen, dass die Prozessparameter, wie beispielsweise die Mischungsverhältnisse der Prozessgase, die eingebrachte elektrische oder thermische Leistung, die Entfernung von den Materialquellen zum Wischergummi, Strömungsverhältnisse usw., verändert werden, dass eine stufenlose Gradientenschicht erreicht wird, d.h. eine Schicht, deren Stoffparameter und Stoffeigenschaften von innen nach außen, senkrecht zum Wischergummi entsprechend chemischen und morphologischen Gradienten folgt und in einer Ebene in Längsrichtung des Wischergummis jeweils konstante Eigenschaften besitzt. Kostengünstiger und bei verschiedenen Randbedingungen in der Fertigung kann es jedoch von Vorteil sein, die Prozessparameter stufenweise zu verändern und dadurch eine Multilagenschicht zu erzeugen, d.h. mehrere dünne, von den Stoffeigenschaften geringfügig abweichende Schichten übereinander.

Die Gradientenschicht oder die Multilagenschicht kann gleichzeitig die nach außen abschließende, harte, verschleißfeste Schicht bilden. Möglich ist auch, dass die verschleißfeste, harte Schicht separat, d.h. als abgesetzte Stufe aufgebracht wird. In einer Ausgestaltung der Erfindung wird vorgeschlagen, abschließend zusätzlich eine trockenschmierende und/oder hydrophobe Schicht aufzubringen. Bewährt haben sich Schichten mit einem Wasserbenetzungsrandwinkel zwischen 60 Grad und 150 Grad, vorzugsweise über 90 Grad.

Als Beschichtungsmaterialien eignen sich besonders halogen-, silizium-, kohlenstoffhaltige und/oder metallorganische Materialien bzw. Monomere, d.h. niedermolekulare, vernetzbare Stoffe, wobei der Kohlenstoff-, Stickstoff-, Sauerstoff-, Fluor- und/oder Metallgehalt von innen nach außen verändert werden, dass die Härte bzw. die Verschleißfestigkeit im Schichtsystem zunimmt. Eine günstige Multilagenschicht oder Gradientenschicht wird beispielsweise mit einem siliziumhaltigen Gemisch erreicht, dem während des Prozesses zunehmend Kohlenstoff beigemischt wird, d.h. in einem chemischen Gradienten in ein zunehmend kohlenstoffhaltiges Gemisch übergeht. Für die nach außen abschließende Schicht eignen sich besonders kohlenstoffreiche, halogenhaltige und/oder metallhaltige Verbindungen, für deren Herstellung sich insbesondere fluorhaltige Gase, sauerstoffarme Siloxan-Monomere und Kohlenwasserstoff-Gase bewährt haben. Die Schichtoberfläche erhält dadurch die gewünschte hydrophobe und/oder trockenschmierende Eigenschaft und damit gute Gleiteigenschaften, insbesondere auf hydrophilen Windschutzscheiben. Bei einer oxidischen oder nitridischen Multilagenschicht oder Gradientenschicht kann ein höherer Reibkoeffizient entstehen, wodurch eine zusätzliche, die Gleiteigenschaft verbessernde, hydrophobe abschließende Schicht besonders von Vorteil ist. Die abschließende hydrophobe Schicht bleibt durch eine kovalente Verbindung mit der Multilagenschicht oder der Gradientenschicht lange erhalten.

Um den Halt des gesamten Schichtsystems zu verbessern, wird in einer Ausgestaltung der Erfindung vorgeschlagen, den Wischergummi thermisch, photochemisch und/oder plasmaunterstützt zu reinigen und/oder zu aktivieren, beispielsweise mit halogen-, sauerstoff- und/oder stickstoffhaltigen Gasen. Die Feinreinigung bzw. das Aktivieren und/oder Aufrauen der Oberfläche durch ein Plasma erfolgt vorzugsweise mit Mikrowellenanregung und/oder einer Vorspannung oder mit einer Frequenzquelle, die bei 13,56 MHz betrieben wird, und einer sich selbst einstellenden Vorspannung. Die Vorspannung liegt an einer Elektrode an, über die der Wischergummi mit der Rückseite des zu reinigenden Bereichs geführt wird. Ferner kann der Halt des Schichtsystems mit einer unmittelbar auf den Wischergummi aufgebrachten metallischen, organischen und/oder silizium- stickstoffhaltigen Haftvermittlerschicht verbessert werden. Diese Schicht ist in der Regel nur wenige 10 nm dick.

Die Beschichtungsmaterialien können durch Wärme, durch ein Plasma und/oder durch Laser in einen dampfförmigen Zustand versetzt und/oder in einem bereits dampfförmigen Zustand in ihren Bestandteilen weiter aufgespalten werden. Thermisch aktivierte CVD-Verfahren besitzen zwar den Nachteil, dass in der Regel der Wischergummi höheren thermischen Belastungen ausgesetzt ist, jedoch kann die Wärme gleichzeitig günstig zur Vorbehandlung genutzt und ein dichteres Schichtwachstum erreicht werden.

In einer Ausgestaltung wird vorgeschlagen, dass zumindest ein Verfahren plasmaunterstützt betrieben wird. Bei einem plasmaaktivierten CVD-Verfahren kann zwischen einem thermisch erregt heißen und einem durch eine Frequenzquelle erregten kalten Plasma unterschieden werden. Anregungsfrequenzen im Bereich von 50 KHz bis 2,45 GHz können Anwendung finden, vorzugsweise 2,45 GHz mit Magnetfeldunterstützung (ECR), besonders bevorzugt bei 13,56 MHz. Bei einem thermischen Plasma kann die Wärme genutzt werden den Wischergummi zu behandeln bzw. zu aktivieren. Es werden hohe Abscheideraten und damit kostengünstige Schichtsysteme erreicht. Um in sich elastische Schichtsysteme mit möglichst geringen Spannungen zu erhalten, werden die Monomere vorzugsweise in die kälteren Bereiche des Plasmas zugeführt. Die Monomere werden dadurch nicht in ihre atomaren Bestandteile fragmentiert und bilden eine weichere und in sich elastische Schicht. Ferner wird ein schnelles Schichtwachstum und eine geringere thermische Belastung des Wischergummis erreicht.

Ist das Plasma durch eine Frequenzquelle erzeugt, beispielsweise durch eine Hochfrequenz-, Radiofrequenz- oder Mikrowellenfrequenzquelle, können gegenüber reinen CVD-Verfahren thermische Belastungen des Wischergummis minimiert werden. Mit der eingesetzten Frequenz nehmen der Radikalanteil, die Abscheiderate und das Schichtwachstum zu und die Verfahrenskosten ab.

Die Plasmaquellen können kontinuierlich und/oder gepulst betrieben werden. Bei einem gepulsten Betrieb kann sich der Wischergummi in den Pausen von einem Beschuss von Radikalen, geladenen Teilchen usw. und insbesondere von thermischen Belastungen erholen. Kalte Gasmoleküle können die Wärme vom Wischergummi weg transportieren. Ferner kann ein höheres Schichtwachstum erzielt werden, indem die Monomere vorreagieren können und somit zu einer höheren Abscheiderate führen.

Der Wischergummi kann unmittelbar durch das Plasma oder am Plasma vorbei geführt und dabei beschichtet werden. Bei der Beschichtung im Plasma ist die thermische Belastung des Wischergummis höher, jedoch können bei schnellem Schichtwachstum harte verschleißfeste Schichten in kürzerer Prozesszeit erreicht werden. Bei der Beschichtung außerhalb des Plasmas wird der Wischergummi weniger belastet, die Monomere können auf dem Weg zum Wischergummi vorreagieren, wodurch trotz der Verluste durch den größeren Abstand hohe Abscheideraten, ein schnelles Schichtwachstum und weichere Schichten erzielt werden. Möglich ist auch, dass der Wischergummi zu Beginn außerhalb des Plasmas mit einer weicheren, dem Material des Wischergummis angepassten Schicht und zum Ende im Plasma mit einer härteren, verschleißfesteren Schicht beschichtet wird.

Die plasmagestützte Abscheidung der Schicht kann durch eine am Wischergummi angelegte Vorspannung zu dichteren und verschleißfesteren Schichten führen. Dabei wird der Wischergummi - wie bei der Reinigung beschrieben - über eine Elektrode geführt, die auf Potential (Vorspannung) liegt. Diese Vorspannung (Bias) wird gegen Masse oder eine Gegenelektrode gepulst oder ungepulst geführt. Dabei finden Pulsfrequenzen zwischen 10 KHz und einigen MHz Verwendung, bevorzugt 50 bis 250 KHz. Die Vorspannung kann aber auch von einer Frequenzquelle gespeist werden mit Freqenzen zwischen 1 kHz und 100 MHz, bevorzugt zwischen 50 kHz bis 27 MHz, besonders bevorzugt 13,56 MHz. Durch die Vorspannung werden Ionen aus dem Plasma in Richtung der Wischergummioberfläche beschleunigt und führen durch Stöße mit der bereits abgeschiedenen Schicht zu einer Neuvernetzung/Verdichtung der Schicht. Vorteilhaft stellt sich die Vorspannung selbstständig ein und kann einen Wert zwischen wenigen Volt und 2 Kilovolt annehmen.

In einer Ausgestaltung der Erfindung wird vorgeschlagen, ein laseraktiviertes Verfahren, insbesondere CVD-Verfahren mit einem oder mehreren Lasern einzusetzen. Durch einen Laser, beispielsweise einen Excimer-Laser, kann die Energie in einem örtlich begrenzten, exakt bestimmbaren Bereich eingebracht werden. Das Schichtsystem kann dadurch gezielt nur in dem örtlich begrenzten Bereich des Wischergummis aufgebracht werden, vorzugsweise nur im Kontaktbereich mit der Windschutzscheibe. Der Wischergummi wird nur in sehr geringen Bereichen thermisch belastet und die Elastizität des restlichen Wischergummis wird nicht beeinflusst, insbesondere nicht im Bereich des Kippstegs, wodurch der Umklappvorgang durch die Beschichtung und das Schichtsystem nicht beeinflusst werden. Der Stoffeinsatz und Energieaufwand werden gesenkt und die Anlagenkontamination wird verringert. Ein weiterer verfahrenstechnischer Vorteil ist, dass Laser-Beschichtungen stets lineare Prozesse sind, da die Energie auf einen Spot mit geringem Durchmesser konzentriert wird. Flächige Beschichtungen werden durch rasternde Führung des Laserstrahls erreicht. Wischergummikanten sind linienförmige Substrate, die prinzipiell ohne Rastern des Strahls beschichtet werden können. Dies erspart optomechanische Führungselemente, Adaption an unterschiedliche Substrate, einfache Synchronisation von mehreren Strahlen, z.B. für die Voraktivierung, die eigentliche Beschichtung und die Nachvernetzung.

Alle Beschichtungsverfahren können so durchgeführt werden, dass der Wischergummi beidseitig - und zwar gleichzeitig (z.B. mit 2 Beschichtungslasern) oder nacheinander -, nur einseitig, die gesamte Oberfläche oder nur partiell (z.B. wie oben für das Laserverfahren beschrieben nur die Wischlippe) beschichtet wird.

Als reine PVD-Verfahren haben sich das Plasmaspritzen und das Sputtern bzw. die Kathodenzerstäubung bewährt. Gegenüber einem Aufdampfverfahren, bei dem das verdampfgut so hoch erhitzt wird, bis der Dampfdruck für ein Abdampfen ausreicht, können bei der Kathodenzerstäubung die Schichtzusammensetzungen besser kontrolliert und damit gleichmäßigere Übergänge erzielt werden. Das Kathodenzerstäuben ist außerdem ein Verfahren, das die Atome und Atomverbünde bei niedrigeren Temperaturen abscheidet. Mit diesem Verfahren wird die Temperaturbelastung des Substrats besser kontrolliert. Darüber hinaus existieren beim Kathodenzerstäuben wie bei den anderen plasmagestützten Verfahren im Dampf Ionen, die durch Anlegen einer Vorspannung an das Substrat - im Falle des Wischergummis kann das ein Metallstreifen sein, über den die Wischlippe geführt wird - auf die Schicht gezogen werden können und diese zu verdichten vermögen.

Der Kontur des Wischergummis angepasst ist eine Hohlkathodenquelle, die eine Linearquelle darstellt und zur Kathodenzerstäubung vorzugsweise eingesetzt werden kann. Mit dieser Quelle können hohe Abscheideraten und gleichzeitig gute Schichtqualitäten erreicht werden. Ferner besitzt die Hohlkathode zwischen Anodenfläche und Kathodenfläche einen geradlinigen großen Abstand, wodurch beim Betrieb der Quelle eine geradlinige Strömung zwischen Kathode und Anode entsteht, die verhindert, dass die Kathode vergiftet bzw. zugesetzt wird.

Beim Plasmaspritzen wird ein Pulver oder eine Flüssigkeit einem Plasmajet zugeführt, der über einen Lichtbogen gezündet wird, an- bzw. aufgeschmolzen zum Wischergummi beschleunigt und auf diesem abgelagert wird. Die Wärme des Plasmas kann gleichzeitig zur Vorbehandlung des Wischergummis genutzt und es kann ein besonders schnelles Schichtwachstum erreicht werden.

Grundsätzlich können die Verfahren im Vakuum und/oder bei Atmosphäre durchgeführt werden. In einer Ausgestaltung der Erfindung wird vorgeschlagen, die Verfahren bei Atmosphäre oder zumindest bei möglichst geringem Vakuum durchzuführen, wodurch zwar tendenziell grobkörnigere, weichere Schichten entstehen, jedoch auf kostenintensive Vakuumanlagen verzichtet und in der Regel eine höhere Abscheiderate erzielt werden kann.

Für Beschichtungen bei Atmosphäre oder bei geringem Vakuum haben sich Corona- und/oder Barriereentladungsquellen und/oder Plasmaspritzquellen besonders bewährt. Mit diesen Quellentechniken können hohe Abscheideraten und dadurch kostengünstige Beschichtungen erreicht werden. Die Schicht wird von der Struktur her weich und kann dadurch besonders günstig im inneren Bereich den Eigenschaften des Wischergummis angepasst werden.

Die beschriebenen PVD-Verfahren und CVD-Verfahren können jeweils einzeln oder zusammen in verschiedenen Kombinationen eingesetzt werden. Werden mehrere verschiedene Verfahren eingesetzt, ist es vorteilhaft, für den inneren Schichtbereich Verfahren einzusetzen, mit denen ein schnelles Schichtwachstum und weiche, dem Material des Wischergummis angepasste Schichten erzeugt werden können. Für den äußeren härteren und dünneren Bereich eignen sich Verfahren, mit denen mit einem geringeren Schichtwachstum harte verschleißfeste Schichten geschaffen werden können. Vorzugsweise wird die Beschichtung in einen kontinuierlichen Fertigungsfluss eingebunden, wodurch Raum, Zeit und Kosten eingespart werden können. Dafür eignen sich besonders Durchlaufkonzepte, bei denen die Wischergummis im Strang extrudiert und durch die differenziell gepumpte Vakuumkammer bzw. Reaktionskammer unter atmosphärischem Druck an den Beschichtungsquellen vorbeigeführt werden.

### Zeichnung

Weitere Vorteile ergeben sich aus der folgenden detaillierten Beschreibung. In der Zeichnung ist ein Ausführungsbeispiel der Erfindung dargestellt.

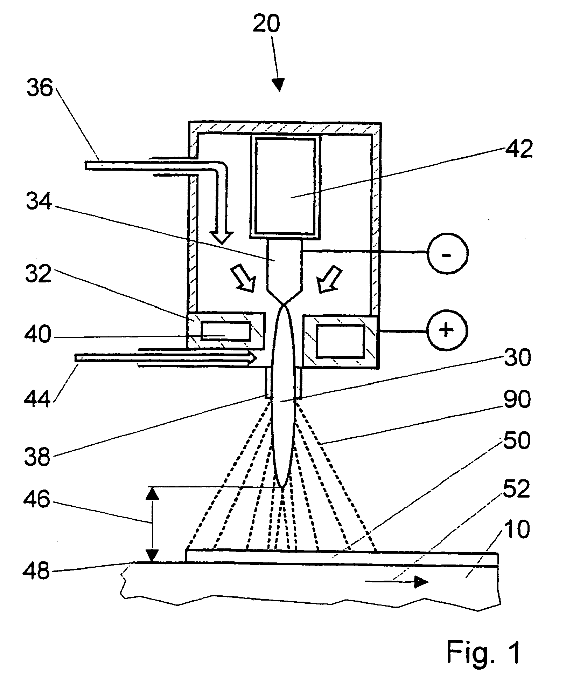

Die einzige Fig.1 zeigt einen Wischergummi und eine schematisierte Plasmaquelle, hier: eine Plasmaspritzquelle,

### Beschreibung der Ausführungsbeispiele

In der Fig. 1 ist schematisch eine Plasmaquelle 20 mit einer ringförmigen Anode 32 und einer stabförmigen Kathode 34 dargestellt. Auf einer Seite der Plasmaquelle 20 wird ein Plasmagas 36 zugeführt, das an der Kathode 34 vorbei durch die Anode 32 strömt und dabei in einen plasmaförmigen Zustand versetzt bzw. zu einem heißen Plasma 30 erregt wird. Das Plasma 30 wird durch eine Düse 38 entsprechend geformt. Um zu vermeiden, dass die Kathode 34, die Anode 32 und die Düse 38 verbrennen bzw. anschmelzen, sind diese durch Kühlwasserkanäle 40, 42 gekühlt.

Dem Plasma 30 wird im Bereich der Anode 32 ein Monomergas 44 zugeführt, das von dem Plasma 30 fragmentiert und in Richtung eines Wischergummis 10 geschleudert wird. Der Wischergummi 10 wird mit einem Abstand 46 am Plasma 30 in Richtung 52 vorbei geführt, sodass das fragmentierte Monomergas 90 auf dem Weg zum Wischergummi 10 Zeit hat vorzureagieren. Möglich ist jedoch auch, dass der Wischergummi 10 durch das Plasma 30 geführt und dabei beschichtet wird. Das fragmentierte Monomergas 90 lagert sich auf dem Wischergummi 10 ab und reagiert an dessen Oberfläche 48 zu einem hochvernetzten Schichtsystem 50. Möglich ist auch, dass anstatt dem Monomergas 44 ein pulverförmiges Beschichtungsmaterial dem Plasma 30 zugeführt, von diesem aufgeschmolzen, in Richtung des Wischergummis 10 geschleudert wird und an dessen Oberfläche 48 mit oder ohne chemische Reaktion ein Schichtsystem oder eine einzelne Schicht bildet.

Bei einer Varianten sind mehrere Plasmaquellen in einer Reihe hintereinander angeordnet, an denen der Wischergummi 10 in Richtung 52 vorbeigeführt wird. Um in senkrechter Richtung zum Wischergummi 10 innerhalb des Schichtsystems 50 unterschiedliche Stoffeigenschaften zu erzielen, werden die Plasmaquellen mit unterschiedlichen Gaszusammensetzungen bzw. Gaskonzentrationen betrieben. Möglich ist auch, dass die Plasmaquellen mit unterschiedlich hoher Leistung betrieben oder unterschiedlich weit vom Wischergummi 10 angeordnet werden.

Mit den unterschiedlichen Plasmaquellen können viele dünne, unterschiedliche, aufeinander folgende Schichten, auch als Multilagenschicht bezeichnet, und/oder eine Gradientenschicht erzielt werden, in der sich die Stoffparameter und die Stoffeigenschaften entsprechend einem oder mehrerer chemischer Gradienten stufenlos verändern. Die Gradientenschicht wird durch entsprechend kurz hintereinander angeordnete Plasmaquellen erreicht oder indem der Wischergummi 10 entsprechend schnell an den Plasmaquellen vorbeigeführt wird. Die Beschichtungsmaterialien vermischen sich dabei auf der Oberfläche 48 des Wischergummis 10. Ferner können die fragmentierten Monomergase 90 bereits bevor sie auf den Wischergummi 10 auftreffen, durch erzeugte Strömungen oder durch entsprechende Ausstrahlungswinkel der Plasmaquellen vermischt werden. Möglich ist auch, dass der Wischergummi 10 schrittweise weiterbewegt wird, die Plasmaquellen untereinander gleich betrieben werden, jedoch die Gaszusammensetzung und/oder die Energiezufuhr über der Zeit verändert werden, um eine Gradientenschicht oder eine Multilagenschicht zu erzeugen. Ein kontinuierlicher Beschichtungsvorgang kann jedoch günstiger in einen Fertigungsablauf eines Wischergummis 10 eingebunden werden.

Um einen besseren Halt des Schichtsystems 50 zu erreichen, kann in einem ersten Schritt eine Haftvermittlerschicht auf den Wischergummi 10 aufgebracht werden. Anschließend wird dann eine Gradientenschicht oder eine Multilagenschicht aufgebracht. Das Schichtsystem 50 schließt mit einer harten, dünnen und verschleißfesten Schicht ab. Möglich ist auch, dass der Wischergummi 10 nur mit einer Gradientenschicht oder nur mit einer Multilagenschicht beschichtet wird.

Das Schichtsystem 50 ist im inneren Bereich am Wischergummi 10 elastisch weich und damit den Stoffeigenschaften des meist aus Elastomer gebildeten Wischergummis 10 angepasst. In senkrechter Richtung zum Wischergummi 10 nimmt die Härte bis zur äußersten Schicht zu. Damit wird ein verschleißfestes, in sich flexibles Schichtsystem 50 erreicht, das sich Verformungen des Wischergummis 10 anpassen kann und sicher auf lange Zeit mit dem Wischergummi 10 verbunden ist. Neben einem kontinuierlichen Härteanstieg innerhalb des Schichtsystems 50 kann es sinnvoll sein, zwischen harten und weichen Schichtebenen zu variieren, beispielsweise weich, hart, weich, hart, um dadurch die Elastizität des Schichtsystems zu verbessern und/oder Spannungen abbauen zu können. Das Schichtsystem 50 ist vorzugsweise zwischen 200 nm und 2 µm dick.

Eine unter Vakuum betriebene Beschichtungsanlage kann in einen Fertigungsprozess eines Wischergummis 10 eingebunden sein. Das Elastomer wird in einem ersten Schritt in einer Vorrichtung zu einem strangförmigen Wischergummi 10 extrudiert. Anschließend läuft der Wischergummi 10 in die Beschichtungsanlage. Im mittleren Bereich der Beschichtungsanlage befindet sich eine mit Hochvakuumpumpen verbundene Beschichtungskammer mit Beschichtungsquellen.

Die Hochvakuumpumpen werden zerstört, wenn sie gegen Atmosphäre betrieben werden. Um dies zu vermeiden, sind im vorderen und hinteren Bereich der Beschichtungsanlage mit Grobvakuumpumpen verbunden Vorvakuumkammmern angeordnet. Die Vakuumpumpen, insbesondere die Hochvakuumpumpen sind vorzugsweise im oberen Bereich der Beschichtungsanlage angeordnet, wodurch möglicherweise auftretende größere, nach unten sinkende Teilchen des Beschichtungsmaterials nicht in die Vakuumpumpen gelangen und diese zerstören. Die Plasmaquellen können dabei oberhalb der Substratdurchführung oder an den Seiten der Beschichtungskammer angeordnet sein und gleichzeitig auf beiden Seiten des Substrats beschichten oder sukzessive erst eine Seite dann die andere.

Nach der Beschichtungsanlage wird der Wischergummi 10 in einer Vorrichtung in erforderlichen Längen vereinzelt. Dies kann in einer anderen vorteilhaften Ausführung auch vor der Beschichtungsanlage erfolgen.

## Patentansprüche

1. Beschichtungsverfahren eines Wischergummis (10) aus Elastomermaterial, bei dem durch ein pysikalischer und/oder chemikalischer Dampfablagerungsverfahren ein dampfförmiges Beschichtungsmaterial (90) durch ein Plasma und/oder Laser generiert und aktiviert wird, und eine verschleißfeste Schutzschicht (50) mit guten Gleiteigenschaften auf der Oberfläche (48) des Wischergummis gebildet wird, **dadurch gekennzeichnet, dass** die Schutzschicht (50) zwischen 200 nm und 2 µm dick ist und dass während der Wischergummi beschichtet wird, die Prozessparameter einfach variiert werden. Sodass im inneren Bereich am Wischergummi ein elastisch-weiches, den Eigenschaften des Wischergummis angepaßtes und ein nach außen hartes, verschleißfestes Schichtsystem in einem Prozeß erreicht wird.

2. Verfahren nach Anspruch 1, **dadurch gekennzeichnet, dass** harte und weiche Schichtebene variieren, beispielsweise weich, hart, weich hart.

3. Verfahren nach Anspruch 1, **dadurch gekennzeichnet, dass** die Härte der Schutzschicht nach außen als Gradientenschicht zunimmt, indem während der Beschichtung die Prozessparameter fließend variiert werden.

4. Verfahren nach einem der Ansprüche 1 oder 2, **dadurch gekennzeichnet, dass** die Prozessparameter stufenweise verändert werden und eine Multilagenschicht (14) aufgebracht wird.

5. Verfahren nach einem der vorhergehenden Ansprüche, **dadurch gekennzeichnet, dass** abschließend eine hydrophobe und/oder trockenschmierende Schicht aufgebracht wird, deren Wasserbenetzungsrandwinkel zwischen 60 und 150 Grad vorzugsweise 90° liegt.

6. Verfahren nach einem der vorhergehenden Ansprüche, **dadurch gekennzeichnet, dass** der Wischergummi (10) plasmaunterstützt mit einer Mikrowellenanregung bei 13,56 MHz vorbehandelt wird, wobei an den Wischergummi (10) über eine Elektrode eine Vorspannung angelegt ist.

7. Verfahren nach einem der vorhergehenden Ansprüche, **dadurch gekennzeichnet, dass** zu Beginn auf den Wischergummi (10) eine 10 nm dünne Haftvermittlerschicht aus metallischen, organischen und/oder siliziumshaltigen Stoffen aufgebracht wird.

8. Verfahren nach einem der vorhergehenden Ansprüche, **dadurch gekennzeichnet, dass** das Beschichtungsmaterial durch ein Plasma (30) aktiviert wird, das mit einer Frequenzquelle mit einer Frequenz zwischen 50 KHz und 2,45 GHz erzeugt wird, und dass dem Plasma (30) im Bereich einer Anode (32) ein Monomergas (44) oder ein pulverförmiges Beschichtungsmaterial zugeführt wird.

9. Verfahren nach Anspruch 8, **dadurch gekennzeichnet, dass** die Frequenzquelle bei 2,45 GHz und mit Magnetfeldunterstützung (ECR) betrieben wird.

10. Verfahren nach Anspruch 8, **dadurch gekennzeichnet, dass** die Frequenzquelle bei 13,56 MHz betrieben wird.

11. Verfahren nach einem der Ansprüche 8 bis 10, **dadurch gekennzeichnet, dass** die Plasmaquellen gepulst betrieben werden.

12. Verfahren nach einem der Ansprüche 9 bis 13, **dadurch gekennzeichnet, dass** der Wischergummi (10) zu Beginn außerhalb des Plasmas (30) mit einer weicheren, dem Wischergummi (10) angepassten Schichtlage und zum Ende im Plasma (30) mit einer härteren, verschleißfesteren Schichtlage beschichtet wird.

13. Verfahren nach einem der vorhergehenden Ansprüche, **dadurch gekennzeichnet, dass** das Beschichtungsmaterial durch einen Laser aktiviert wird und der Wischergummi (10) nur in einem Bereich beschichtet wird, mit dem er mit der Windschutzscheibe in Kontakt kommt.

14. Verfahren nach einem der vorhergehenden Ansprüche, **dadurch gekennzeichnet, dass** der Wischergummi (10) bei Atmosphäre oder geringem Vakuum durch ein Plasmaspritzverfahren beschichtet wird, bei dem eine Hohlkathodenquelle, eine Corinna- und/oder Barriereentladungsquelle verwendet werden.

15. Verfahren nach einem der vorhergehenden Ansprüche, **dadurch gekennzeichnet, dass** die Beschichtung plasmagestützt erfolgt und Ionen aus dem aktivierten Dampf durch eine hinter dem Wischergummi (10) angeordnete Elektrode, die eine Vorspannung aufweist, auf die Schutzschicht (50) gezogen werden.

16. Verfahren nach Anspruch 15, **dadurch gekennzeichnet, dass** die Vorspannung gepulst angelegt wird, wobei die Pulsfrequenz zwischen 10 KHz und einigen MHz liegt.

17. Verfahren nach Anspruch 16, **dadurch gekennzeichnet, dass** die Pulsfrequenz zwischen 50 bis 250 KHz liegt.

18. Verfahren nach einem der vorhergehenden Ansprüche, **dadurch gekennzeichnet, dass** es in einen kontinuierlichen Fertigungsfluss eingebunden ist, der mit einer differenziell gepumpten Durchlaufanlage realisiert wird, bei der im vorderen und hinteren Bereich der Beschichtungsanlage mit Grobvakuumpumpen verbundene Vorvakuumkammern und im oberen Bereich der Beschichtungsanlage Hochvakuumpumpen angeordnet sind.

19. Verfahren nach Anspruch 18, **dadurch gekennzeichnet, dass** mehrere Plasmaquellen in einer Reihe hintereinander angeordnet sind, an denen der Wischergummi (10) vorbeigeführt wird und die mit unterschiedlichen Gaszusammensetzungen bzw. Gaskonzentrationen betrieben werden.

## Claims

1. Method for coating a wiper blade rubber (10) composed of elastomer material, in which by means of a physical and/or chemical vapour deposition method a vaporous coating material (90) is generated and activated by a plasma and/or laser, and a wear-resistant protective layer (50) with good sliding properties is formed on the surface (48) of the wiper blade rubber, **characterized in that** the protective layer (50) is between 200 nm and 2 µm thick and **in that** while the wiper blade rubber is coated, the process parameters are varied in a simple manner, so that in one process a layer system which is elastically soft and is matched to the properties of the wiper blade rubber and a layer system which is outwardly hard and is wear-resistant are achieved on the wiper blade rubber in the inner region.

2. Method according to Claim 1, **characterized in that** hard and soft layer planes vary, for example soft, hard, soft, hard.

3. Method according to Claim 1, **characterized in that** the hardness of the protective layer increases outwards as a gradient layer by the process parameters being varied fluidly during the coating.

4. Method according to either of Claims 1 and 2, **characterized in that** the process parameters are changed in a stepwise manner and a multilayer layer (14) is applied.

5. Method according to one of the preceding claims, **characterized in that** finally a layer which is hydrophobic and/or forms a dry-film lubrication is applied, the water wetting angle of which is between 60 and 150 degrees, preferably 90°.

6. Method according to one of the preceding claims, **characterized in that** the wiper blade rubber (10) is pre-treated under plasma assistance with a microwave excitation at 13.56 MHz, with a bias voltage being applied to the wiper blade rubber (10) via an electrode.

7. Method according to one of the preceding claims, **characterized in that** at the beginning a 10 nm thin adhesion-promoting layer of metallic, organic and/or silicon-containing materials is applied to the wiper blade rubber (10).

8. Method according to one of the preceding claims, **characterized in that** the coating material is activated by a plasma (30) which is generated by a frequency source at a frequency of between 50 kHz and 2.45 GHz, and **in that** a monomer gas (44) or a pulverulent coating material is supplied to the plasma (30) in the region of an anode (32).

9. Method according to Claim 8, **characterized in that** the frequency source is operated at 2.45 GHz and with the assistance of a magnetic field (ECR).

10. Method according to Claim 8, **characterized in that** the frequency source is operated at 13.56 MHz.

11. Method according to one of Claims 8 to 10, **characterized in that** the plasma sources are operated in a pulsed manner.

12. Method according to one of Claims 9 to 11, **characterized in that** the wiper blade rubber (10) is coated, at the beginning outside the plasma (30), with a softer coating layer matched to the wiper blade rubber (10), and, at the end in the plasma (30), is coated with a harder, more wear-resistant coating layer.

13. Method according to one of the preceding claims, **characterized in that** the coating material is activated by a laser and the wiper blade rubber (10) is coated only in a region with which it comes into contact with the windscreen.

14. Method according to one of the preceding claims, **characterized in that** the wiper blade rubber (10) is coated at atmospheric pressure or under a low vacuum by a plasma-spraying method, in which a hollow cathode source, a Corinna and/or a barrier discharge source is used.

15. Method according to one of the preceding claims, **characterized in that** the coating takes place with plasma assistance, and ions from the activated vapour are drawn by an electrode, which is arranged behind the wiper blade rubber (10) and has a bias voltage, onto the protective layer (50).

16. Method according to Claim 15, **characterized in that** the bias voltage is applied in a pulsed manner, the pulse frequency being between 10 kHz and a few MHz.

17. Method according to Claim 16, **characterized in that** the pulse frequency is between 50 and 250 kHz.

18. Method according to one of the preceding claims, **characterized in that** it is integrated into a continuous process flow which is realized using a differentially pumped continuous installation, in which pre-vacuum chambers which are connected to rough vacuum pumps are arranged in the front and rear region of the coating installation and high-vacuum pumps are arranged in the upper region of the coating installation.

19. Method according to Claim 18, **characterized in that** a plurality of plasma sources are arranged in a row one behind another, past which the wiper blade rubber (10) is guided, and which are operated with different gas compositions or gas concentrations.

## Revendications

1. Procédé d'enduction d'une raclette d'essuie-glace (10) en élastomère selon lequel on génère et on active par un procédé de dépôt à la vapeur physique et/ou chimique, une matière d'enduction (90) à l'état de vapeur par un plasma et/ou un laser, et on forme une couche protectrice (50) résistante à l'abrasion et ayant de bonnes caractéristiques de glissement sur la surface (48) de la raclette d'essuie-glace,
**caractérisé en ce que**
la couche protectrice (50) a une épaisseur comprise entre 200 nm et 2 µm, et
pendant l'enduction de la raclette, on modifie simplement les paramètres du procédé de façon à obtenir au coeur de la raclette, un système stratifié élastiquement mou, adapté aux propriétés de la raclette et vers l'extérieur un système stratifié dur, résistant à l'abrasion.

2. Procédé selon la revendication 1,
**caractérisé en ce qu'**
on fait varier des plans de couches dures et molles, par exemple mou, dur, mi-dur.

3. Procédé selon la revendication 1,
**caractérisé en ce que**
la durée de la couche protectrice augmente vers l'extérieur suivant un gradient de revêtement.

4. Procédé selon l'une des revendications 1 ou 2,
**caractérisé en ce qu'**
on modifie par étape les paramètres du procédé et on applique une enduction multicouches (14).

5. Procédé selon l'une des revendications précédentes,
**caractérisé en ce que**
finalement on applique une couche hydrophobe et/ou lubrifiée à sec dont l'angle de mouillabilité est compris entre 60 et 150°, et de préférence 90°.

6. Procédé selon l'une des revendications précédentes,
**caractérisé en ce que**
la raclette (10) est traitée au préalable sous assistance plasma à une excitation par micro-ondes à une fréquence de 13,56 MHz, et avec une électrode appliquant une tension de polarisation à la raclette (10).

7. Procédé selon l'une des revendications précédentes,
**caractérisé en ce qu'**
au début on applique sur la raclette (10) une couche mince, favorisant l'adhésion, d'une épaisseur de 10 nm en une matière métallique, organique et/ ou contenant du silicium.

8. Procédé selon l'une quelconque des revendications précédentes,
**caractérisé en ce que**
la matière d'enduction est activée par un plasma (30), généré par une source de fréquence travaillant avec une fréquence comprise entre 50 KHz et 2,45 GHz, et
on alimente le plasma (30) au niveau d'une anode (32) par un gaz monomère (44) ou une matière d'enduction pulvérulente.

9. Procédé selon la revendication 8,
**caractérisé en ce qu'**
on fait fonctionner la source de fréquence à 2,45 GHz et avec un champ magnétique de soutien (ECR).

10. Procédé selon la revendication 8,
**caractérisé en ce que**
la source de fréquence fonctionne à une fréquence de 13,56 MHz.

11. Procédé selon l'une des revendications 8 à 10,
**caractérisé en ce que**
la source de plasma fonctionne de manière pulsée.

12. Procédé selon l'une des revendications 9 à 13,
**caractérisé en ce qu'**
on enduit la raclette d'essuyage (10) au début, en dehors du plasma (30) avec une couche d'enduction molle, adaptée à la raclette (10) et à la fin dans le plasma (30) avec une couche d'enduction plus dure, plus résistante à l'abrasion.

13. Procédé selon l'une des revendications précédentes,
**caractérisé en ce que**
la matière d'enduction est activée par un laser et la raclette (10) est seulement revêtue dans la zone arrivant en contact avec le pare-brise.

14. Procédé selon l'une quelconque des revendications précédentes,
**caractérisé en ce qu'**
on enduit la raclette (10) à la pression atmosphérique ou un faible vide par un procédé de pulvérisation au plasma pour lequel on utilise une source à cathode creuse, une source à décharge à effet couronne et/ou à effet barrière.

15. Procédé selon l'une quelconque des revendications précédentes,
**caractérisé en ce que**
l'enduction se fait avec assistance plasma et les ions de la vapeur activée sont attirés par l'électrode de la raclette (10) qui est à une tension de polarisation pour attirer la couche protectrice (50).

16. Procédé selon la revendication 15,
**caractérisé en ce que**
la tension de polarisation est appliquée de manière pulsée à une fréquence de pulsation comprise entre 10 KHz et quelques MHz.

17. Procédé selon la revendication 16,
**caractérisé en ce que**
la fréquence pulsée est comprise entre 50 et 250 KHz.

18. Procédé selon l'une quelconque des revendications précédentes,
**caractérisé en ce qu'**
il est intégré dans une ligne de fabrication continue réalisée avec une installation de passage à pompage différentiel dans laquelle, dans la zone avant et la zone arrière de l'installation d'enduction, il y a des pompes à vide grossier reliées à des chambres de pré-vide et dans la zone supérieure de l'installation d'enduction il y a des pompes à vide poussé.

19. Procédé selon la revendication 18,
**caractérisé par**
plusieurs sources de plasma installées en série l'une derrière l'autre et devant lesquelles passe la raclette de caoutchouc (10) et qui fonctionnent avec des compositions de gaz différentes ou des concentrations de gaz différentes.
